# EUROPEAN PATENT SPECIFICATION

(11) **EP 4 394 881 B1**
(45) Date of publication and mention of the grant of the patent: **30.07.2025**
(21) Application number: 22217357.7
(22) Date of filing: 30.12.2022
(51) Int. Cl.: H10D 12/01, H10D 12/00, H10D 62/10, H10D 62/13, H10D 64/23

(54) **SEMICONDUCTOR DEVICE AND METHOD FOR PRODUCING A SEMICONDUCTOR DEVICE**
HALBLEITERBAUELEMENT UND VERFAHREN ZUR HERSTELLUNG EINES HALBLEITERBAUELEMENTS
DISPOSITIF SEMI-CONDUCTEUR ET PROCÉDÉ DE FABRICATION D'UN DISPOSITIF SEMI-CONDUCTEUR

(43) Date of publication of application: 03.07.2024
(73) Proprietor: Hitachi Energy Ltd, 8050 Zürich (CH)
(72) Inventor: BUITRAGO, Elizabeth, 5210 Windisch (CH); DE MICHIELIS, Luca, 5000 Aarau (CH); VITALE, Wolfgang Amadeus, 6340 Baar (CH); NIKBERG, Babak, 5614 Sarmenstorf (CH)
(74) Representative: Epping - Hermann - Fischer

(56) References cited:
- EP-A1- 4 016 638
- US-A1- 2007 114 570
- US-A1- 2008 042 172
- US-A1- 2009 283 797
- US-A1- 2020 212 209

## Description

The present disclosure relates to a semiconductor device and a method for producing a semiconductor device.

Document US 2009/0283797 A1 provides a semiconductor device in which an amount of fluctuations in output capacitance and feedback capacitance is reduced. In a trench-type insulated gate semiconductor device, a width of a portion of an electric charge storage layer in a direction along which a gate electrode and a dummy gate are aligned is set to be at most 1.4 µm.

Document US 2007/0114570 A1 discloses a power semiconductor device that includes trenches disposed in a first base layer of a first conductivity type at intervals to partition main and dummy cells, at a position remote from a collector layer of a second conductivity type. In the main cell, a second base layer of the second conductivity type, and an emitter layer of the first conductivity type are disposed. In the dummy cell, a buffer layer of the second conductivity type is disposed. A gate electrode is disposed, through a gate insulating film, in a trench adjacent to the main cell. A buffer resistor having an infinitely large resistance value is inserted between the buffer layer and emitter electrode. The dummy cell is provided with an inhibiting structure to reduce carriers of the second conductivity type to flow to and accumulate in the buffer layer from the collector layer.

Document US 2008/0042172 A1 discloses a aemiconductor component having a space saving edge structure. It provides a first side, a second side, an inner region, an edge region adjoining the inner region in a lateral direction of the semiconductor body, and a first semiconductor layer extending across the inner region and the edge region and having a basic doping of a first conductivity type. At least one active component zone of a second conductivity type, which is complementary to the first conductivity type, is disposed in the inner region in the first semiconductor layer. An edge structure is disposed in the edge region and includes at least one trench extending from the first side into the semiconductor body. An edge electrode is disposed in the trench, a dielectric layer is disposed in the trench between the edge electrode and the semiconductor body, a first edge zone of the second conductivity type adjoins the trench and are at least partially disposed below the trench.

Document EP 4 016 638 A1 specifies a power semiconductor device with a semiconductor body extending in a vertical direction between an emitter side with an emitter electrode and a collector side opposite the emitter side, the power semiconductor device comprising: a drift layer of a first conductivity type; a base layer of a second conductivity type different than the first conductivity type extending between the drift layer and the emitter side; a source region of the first conductivity type arranged on a side of the base layer facing away from the drift layer; at least one first trench extending from the emitter side into the drift layer; an insulated trench gate electrode extending into the first trench; at least one second trench extending from the emitter side into the drift layer, the at least one second trench being arranged on a side of the at least one first trench facing away from the source region; an electrically conductive layer extending into the second trench, the electrically conductive layer being electrically insulated from the base layer and the drift layer, wherein a portion of the base layer arranged on a side of the at least one second trench facing away from the at least one first trench extends from the emitter side at least as deep in the vertical direction towards the collector side as the at least one second trench, and a sub-region of the power semiconductor device extending between the at least one first trench and the at least one second trench comprises a plurality of charge carrier extraction contacts electrically connected to the base layer The extraction contacts are arranged beside one another in a direction extending in parallel to a main extension direction of the first trench and the second trench.

Document US 2020/212209 A1 discloses a semiconductor device having an IE-type IGBT structure. The semiconductor device comprises a stripe-shaped trench gate, a stripe-shaped trench emitter arranged to face the trench gate, an N-type emitter layer and a P-type base layer surrounded by the trench gate and the trench emitter, and a P-type base contact layer arranged on one side of the trench emitter, formed in a semiconductor substrate. The p-type base contact layer, the emitter layer, and the trench emitter are commonly connected with an emitter electrodes, and the trench emitter is formed deeper than the trench gate in a thickness direction of the semiconductor substrate.

There is a need for an improved semiconductor device, for example a semiconductor device with improved static and/or dynamic behavior. Furthermore, there is a need for providing a method for producing such a semiconductor device.

This problem is solved by a semiconductor device and a method for producing a semiconductor device according to the independent claims.

First, the semiconductor device is specified.

The semiconductor device, as defined in claim 1, comprises a semiconductor body extending in vertical direction between a top side and a bottom side. A first main electrode is arranged on the top side and a second main electrode is arranged on the bottom side. Furthermore, the semiconductor device comprises a gate electrode and at least two trenches, namely a first-type trench and a second-type trench, each extending from the top side into the semiconductor body. The semiconductor body comprises a drift region of a first conductivity type arranged vertically between the top side and the bottom side and at least two base regions, namely a first and a second base region, each of a second conductivity type and each arranged vertically between the drift region and the top side. The semiconductor body further comprises an injection region of the first conductivity type vertically spaced apart from the drift region by the first base region and adjoining the first base region. The first base region, the first-type trench, the second base region and the second-type trench are arranged in this order one after the other in a first lateral direction. The first main electrode is in electrical contact with the injection region. The gate electrode extends into the first-type trench where it is separated from the semiconductor body by a gate insulation layer. The second-type trench is free of the gate electrode. The second-type trench extends deeper into the semiconductor body than the first-type trench.

The second base region comprises a plurality of laterally spaced contact areas, wherein the second base region is in electrical contact with the first main electrode in each of these contact areas.

The distance between the first-type trench and the second-type trench measured in the first lateral direction varies when moving along a second lateral direction which is perpendicular to the first lateral direction.

The contact areas in the second base region are spaced apart from each other in the second lateral direction.

The distance between the first-type trench and the second-type trench is greater where a contact area is arranged between them and smaller where no contact area is arranged between them.

Long-term performance stability of semiconductor devices, like IGBTs, requires robustness to gate insulation layer degradation. Gate insulation layer degradation can be caused by dynamic avalanches during turn-off switching events at high currents. The charge carriers generated by dynamic avalanche may have enough energy to be injected into the gate insulation layer, modifying the gate capacitance and so the switching characteristics of the semiconductor device (e.g., due to variations of the switching speed and threshold voltage). Gate insulation layer degradation is, in particular, a design challenge for semiconductor devices of trench architecture, due to the peak of avalanche generation near the gate insulation layer at the bottom of the trenches. A technical problem is, therefore, to provide a semiconductor device with an improved trade-off between long-term stability (robustness to gate insulation layer degradation) and static loss.

This problem is solved, inter alia, by the second-type trench being deeper than the first type trench. These kind of second-type trenches turned out to efficiently protect the first-type trenches (which are active trenches) from hot carriers generated by dynamic avalanches, thereby improving robustness to the gate insulation layer degradation in the first-type trench. The improved robustness to gate insulation layer degradation can extend the design space for features that reduce the static loss of the semiconductor device.

The semiconductor device described herein may be a power semiconductor device. For example, it is configured to carry an electric current of at least 10 A and/or to process voltages of at least 1000 V or at least 3000 V. The semiconductor device may be a transistor device, particularly a gate insulated transistor device, particularly an IGFET.

The semiconductor body may be based on silicon or silicon carbide. The thickness of the semiconductor body, measured in vertical direction, is, for example, at least 100 µm or at least 200 µm and/or at most 500 µm. The top side and the bottom side are sides of the semiconductor body and delimit the semiconductor body in vertical direction.

The first and/or the second main electrode may comprise or consist of metal. Depending on the type of semiconductor device, the first electrode may herein also be called "emitter electrode" or "source electrode", respectively, and the second main electrode may be called "collector electrode" or "drain electrode", respectively.

The gate electrode may comprise metal and/or highly-doped polysilicon. The gate electrode is, in particular, an insulated gate electrode, i.e. it is electrically insulated from the semiconductor body. This may be achieved, for example, with the help of the gate insulation layer.

The trenches extend from the top side of the semiconductor body into the semiconductor body and end in the semiconductor body, for example in the drift region. The depths of the trenches, measured in vertical direction, may each be at least 1 µm or at least 5 µm and/or at most 20 µm or at most 10 µm. The trenches may each be elongated and may each extend in a lateral direction, wherein lateral directions are herein defined as directions perpendicular to the vertical direction. Lateral directions are, in particular, directions parallel to a main extension plane of the semiconductor body. For example, the trenches extend parallel to each other.

The first-type trench and the second type trench are spaced apart from each other in a first lateral direction. Each trench may extend in a second lateral direction which is perpendicular to the first lateral direction. An average distance between the first-type trench and the second-type trench is, for example, at least 100 nm or at least 500 nm and/or at most 2 µm. The distance between two trenches is herein defined, for example, as the pitch between the trenches, i.e. the distance between the centers of the trenches. For example, no further trench is arranged laterally between the first-type trench and the second-type trench.

The first-type trench is filled with electrically conductive material which is separated from the semiconductor body by the gate insulation layer. The electrically conductive material is spatially and electrically separated from the semiconductor body by the gate insulation layer. The gate insulation layer may be an oxide, e.g. SiO₂. The thickness of the gate insulation layer may be at least 10 nm and/or at most 200 nm. For example, the thickness of the gate insulation layer is between 50 nm and 150 nm inclusive. "Electrically separated" herein means, in particular, that there is no electrical contact between two elements. Two electrically separated elements are, for example, configured to be independently electrically biased or controlled, respectively. This means that they are configured to lie on different electrical potentials during operation of the semiconductor device. Two electrically separated elements may, in particular, be electrically insulated from each other, i.e. no current flow can occur between them.

The electrically conductive material in the first-type trench may be metal and/or highly-doped polysilicon. The electrically conductive material in the first-type trench is part of the gate electrode, i.e. is electrically connected to the gate electrode. When two elements are electrically connected or are in electrical contact, this means that these two elements are not independently electrically biasable or controllable. Thus, they always lie on the same electrical potential. The first-type trenches are herein also called "active trenches".

For example, the electrically conductive material in the first-type trench reaches at least as deep into the semiconductor body as the first base region and/or as the second base region.

The second-type trench is free of the gate electrode. That is, the second-type trench is a gate electrode free trench. In other words, the second-type trench is electrically separated from the gate electrode.

The second-type trench may also be filled with electrically conductive material which may be separated from the semiconductor body by an insulation layer. However, this electrically conductive material is electrically separated from the gate electrode, i.e. not electrically connected thereto. The insulation layer can be the same as the gate insulation layer. Within the second-type trench, the electrically conductive material may reach as deep into the semiconductor body as the first and/or second base region. The electrically conductive material in the second-type trench may be metal and/or highly-doped polysilicon.

For example, the electrically conductive material in the second-type trench is electrically connected to the first main electrode. In other words, the first main electrode may extend into the second-type trench.

Instead of being filled with electrically conductive material, the second-type trench could be free of electrically conductive material and may, for example, only be filled with an electrically isolating material.

The second-type trench is herein also called "inactive trench".

The drift region of the semiconductor body is of a first conductivity type. The first conductivity type is, for example, n-type, i.e. the drift region is n-doped. The second conductivity type is opposite to the first conductivity type and, therefore, may be p-type. However, the opposite case, in which the first conductivity type is p-type and the second conductivity type is n-type, may also be realized.

The drift region extends, for example, contiguously over all base regions. That is, in top view onto the top side, the drift region overlaps with both base regions.

The first-type trench is arranged between the first base region and the second base region in the first lateral direction. For example, the first-type trench adjoins the first base region on one side and/or the second base region on the other side.

The second base region is arranged between the first-type trench and the second-type trench in the first lateral direction. The second base region may adjoin the second-type trench. The second base region may extend continuously, for example without interruptions, from the first-type trench to the second-type trench.

The structure comprising the first base region and the adjoining injection structure, the first-type trench, the second base region and the second-type trench may be repeated several times along the top side. The structure comprising a at least a portion (half) of the first base region together with the adjoining injection region, the first-type trench, the second base region and the second-type trench are part of a so called "half-cell" or "transistor half-cell". The semiconductor device may comprise several such half-cells which may be arranged one after the other in the first lateral direction. Each two adjacent half-cells may be mirror-symmetric with respect to a mirror plane. The mirror planes extend, for example, perpendicular to the first longitudinal direction. Mirror planes may cross the first base regions at half their respective extensions in the first lateral direction.

The semiconductor body comprises an injection region of the first conductivity type. The injection region is vertically spaced apart from the drift region by the first base region and adjoins the first base region. The injection region reaches, for example, to the top side. The injection region may be embedded in the first base region. For example, the injection region adjoins the first-type trench at the same side as the first base region adjoins the first-type trench. Each half-cell may comprise exactly one such injection region. The injection region is also referred to as source region.

The injection region is in electrical contact with the first main electrode, for example it adjoins the first main electrode. During operation of the semiconductor device in a (static) transistor mode, first-type charge carriers, e.g. electrons, are injected from the first main electrode into the injection region. The semiconductor device is configured such that, by applying a certain potential to the gate electrode, the first base region adjacent to the first-type trench is depleted so that a path for the first-type charge carriers from the injection region towards the drift region is formed, said path extending in vertical direction along the first-type trench.

The second base region may form part of the top side, e.g. the entire portion of the top side which is located laterally between the first-type trench and the second-type trench. For example, the semiconductor body is free of any (injection) region of the first conductivity type arranged vertically between the second base region and the top side and adjoining the second base region.

The depth of the second-type trench, measured in vertical direction, may be at least 0.5 µm or at least 1 µm or at least 1.5 µm or at least 2 µm greater than the depth of the first-type trench. For example, the first-type trench and the second-type trench both extend deeper into the semiconductor body than the first and the second base region.

As mentioned above, the semiconductor body may comprise several first-type trenches and several second-type trenches. Each second-type trench may be deeper than each first-type trench. Particularly, all features disclosed in connection with the one first-type trench and the one second-type trench are also disclosed for all other (pairs of adjacent) first-type trenches and second-type trenches.

According to a further embodiment, the semiconductor device is an IGBT or an RC-IGBT, i.e. a Reverse-Conducting IGBT, or a MISFET, particularly a MOSFET.

According to a further embodiment, a width of the second-type trench is greater than a width of the first-type trench. The width of a trench is herein defined as the average or maximum extension of the trench in lateral direction perpendicular to the main extension direction of the trench. Particularly, the width may be the extension in the first lateral direction. For example, the width of the second-type trench is at least 100 nm or at least 300 nm or at least 500 nm greater than the width of the first-type trench.

The production of this kind of trenches with different depths and widths is particularly easy since the only required change compared to the production of trenches of the same depths is a modified layout in the trench mask. This is because the trench depth is, at least for some etching processes, directly related to the trench width when etching the trenches.

According to a further embodiment, a minimal distance between the first-type trench and the second-type trench, measured in the first lateral direction, is at most two times or at most 1.5-times the width of the second-type trench or is at most this width. The protection of the first-type trench by the second-type trench can be further improved by arranging the second-type trench as close as possible to the first-type trench. The minimal distance is the smallest distance to which adjacent first-type and second-type trenches approach. According to a further embodiment, the first main electrode extends into the second-type trench where it is separated from the semiconductor body by an electrically insulating layer. That is, the second-type trench is filled with electrically conductive material which is electrically connected to the first main electrode. The electrically insulating layer may comprise or consist of the same material as the gate insulation layer. For example, the electrically insulating layer in the second-type trench is formed identically to the gate insulation layer, particularly with respect to the material and/or the thickness.

With the first main electrode extending in the second-type trench, the first-type trench and the second-type trench can be set to different electrical potentials during operation. Alternatively, a further electrode which is independently biasable/controllable from the gate electrode and from the first main electrode may extend into the second-type trench.

According to the invention, the second base region comprises a plurality of contact areas. In the contact areas, the second base region is in electrical contact with an electrode of the semiconductor device which is different from the gate electrode, e.g. it is controllable/biasable independently of the gate electrode.

During operation, charge carriers can be extracted from the semiconductor body via the contact areas. The contact areas may, therefore, also be called "extraction area". Such an extraction area can be advantageous during switching events, e.g. during turn-off of a transistor mode, as it helps to quickly reduce the plasma concentration in the semiconductor body. That is, the contact areas constitute a plasma control feature. On the other hand, if the semiconductor device is operated in a diode mode, the electrical contact of the electrode and the semiconductor body in the contact areas provide a charge carrier path which reduces on-state losses in the diode mode. Since the contact areas are in electrical contact with an electrode which is different from the gate electrode, the path for the charge carriers is independent of the gate electrode potential. The location of the contact areas of the second base region, i.e. at a place which is spaced apart from the first-type trench, helps to protect the gate insulation layer in the first-type trench during switching events because the creation of avalanches in the region of the first-type trench is further reduced.

The second base region is in electrical contact with the first main electrode, in each of these contact areas. The contact areas are spaced apart from each other in lateral direction, e.g. in the first and/or the second lateral direction. All features disclosed in connection with one contact area of the second base region are also disclosed for all other contact areas of the second base region. The device provided with one contact area does not from a part of the present invention but it is useful for its understanding.

In top view onto the top side, the contact areas in the second base region may be formed as stripes or rectangles or squares.

For each pair of adjacent contact areas in the second base region, the two adjacent contact areas are spaced apart from each other. In the regions outside of the contact areas, there is no direct electrical contact between the electrode and the second base region(s). Particularly, outside of the contact areas, the electrode does not adjoin the second base region. For example, the plurality of contact areas of the second base region is arranged in a rectangular pattern when viewed in top view onto the top side. For example, at most 50% and/or at least 10% of the area of the second base region, when seen in this top view, is formed by the contact areas.

The distance between the first-type trench and the second-type trench measured in the first lateral direction varies when moving along the second lateral direction, wherein the second lateral direction is perpendicular to the first lateral direction. For example, the distance varies such that a maximum distance is at least 1.5-times or at least 2-times greater than the minimum distance. The maximum distance is the greatest distance to which the adjacent first-type trench and second-type trench move away from each other.

The contact areas in the second base region are spaced apart from each other in the second lateral direction. For example, the distance between contact areas which are adjacent in the second lateral direction is greater than the maximum distance between the first-type trench and the second-type trench, e.g. at least 2-times or at least 4-times as great as this maximum distance.

The distance between the first-type trench and the second-type trench is greater where a contact area is arranged between them and smaller where no contact area is arranged between them. For example, the distance between the first-type trench and the second-type trench reaches its maximum at the positions where the contact areas in the second base region are located. The positions of the contact areas are their positions along that second lateral direction.

In top view onto the top side, each of the contact areas in the second base region may be surrounded by the second-type trench and the first-type trench. For example, in this top view, each contact area is surrounded by the second-type trench at three sides and by the first-type trench at the remaining fourth side. For example, in top view onto the top side, the second-type trench may have the shape of a rectangular function. The maximum distance between the first-type trench and the second-type trench is reached in each of the rectangles of the rectangular function. In each of the rectangles, one contact area, for example exactly one contact area, is arranged. Within each of the rectangles, the lateral distance of the second-type trench to the contact area may be at most the width of the second-type trench.

According to a further embodiment, the second-type trench is arranged between two first-type trenches in the first lateral direction. All features disclosed in connection with one first-type trench are disclosed for the other first-type trench(es). Particularly, as explained above, the structure of the first base region, the first-type trench, the second base region and the second-type trench may be repeated several times when moving along the first lateral direction.

According to a further embodiment, two second-type trenches are arranged between the two first-type trenches in the first lateral direction. All features disclosed in connection with one second-type trench are also disclosed for the other second-type trench(es). For example, no further trench is arranged laterally between the two second-type trenches.

According to a further embodiment, the second-type trench is arranged between the second base region and a third base region in the first lateral direction. For example, each second-type trench of the semiconductor device may be arranged between a second base region and a third base region. The second-type trench may adjoin the third base region on a side opposite to the side where it adjoins the second base region.

Like the first and the second base region, the third base region is of the second conductivity type. For example, the doping concentration in the third base region is the same as in the first and/or the second base region.

The third base region may extend continuously, e.g. without interruptions, from the second-type trench to a further trench which is spaced apart from the second-type trench in the first lateral direction. The further trench may be another second-type trench.

The third base region may also form part of the top side, e.g. the entire portion of the top side located laterally between the two trenches which laterally delimit the third base region. The semiconductor body may be free of any (injection) region of the first conductivity type arranged vertically between the third base region and the top side and adjoining the third base region.

According to a further embodiment, the third base region extends from the top side at least as deep into the semiconductor body as the second-type trench. For example, the third base region extends deeper into the semiconductor body than the second-type trench. It has been found that, with such a design, the avalanche intensity near the first-type trench can be further reduced.

According to a further embodiment, the third base region extends below the second-type trench towards the first-type trench. Thus, in top view onto the top side, the second-type trench and the third base region may overlap with each other.

According to a further embodiment, the third base region is arranged between the two second-type trenches in the first lateral direction. The third base region may adjoin both second-type trenches.

According to a further embodiment, the two second-type trenches sandwiching the third base region are connected with each other at their respective longitudinal ends, i.e. their ends in the second lateral direction so that, in top view onto the top side, the third base region is completely surrounded by a contiguous trench. In other words, the second-type trenches sandwiching the third base region are formed by one contiguous trench. In top view onto the top side, the contiguous trench forms a frame around the third base region, e.g. a rectangular frame.

According to a further embodiment, the third base region comprises at least one contact area, i.e. one or more, contact areas. In the contact area, the third base region is in electrical contact with an electrode of the semiconductor device which is different from the gate electrode. This electrode may be the same electrode which is in electrical contact with the second base region in the respective (second) contact area. Thus, the electrode may, in particular, be the first main electrode. The contact area of the third base region, herein also reference to as third contact area, may form part of the top side. The third contact area may have a smaller area than the area of the third base region when seen in top view onto the top side. The same relative sizes as disclosed in connection with the (second) contact area of the second base region may apply here as well.

With the contact area of the third base region, a further degree of freedom for optimizing charge carrier extraction, e.g. during turn-off of the transistor mode and/or during diode mode, is realized.

According to a further embodiment, the first base region comprises at least one contact area, i.e. one or more, contact areas. In the contact area, the first base region is in electrical contact with an electrode of the semiconductor device which is different from the gate electrode. This electrode may be the same electrode which is in electrical contact with the second and/or third base region in the respective contact area. Thus, the electrode may, in particular, be the first main electrode.

According to a further embodiment, the drift region comprises a first drift region and a second drift region arranged one after the other in vertical direction. The first drift region and the second drift region may adjoin each other. Both, the first drift region and the second drift region are of the first conductivity type.

According to a further embodiment, the second drift region is arranged vertically between the first drift region and the first base region. For example, the second drift region adjoins the first and/or the second base region.

According to a further embodiment, the second drift region has a greater doping concentration than the first drift region. For example, the average or maximum doping concentration in the second drift region is at least one order or at least two orders of magnitude larger than the average or maximum doping concentration in the first drift region. The doping concentration may gradually/continuously increase from the first drift region to the second drift region. The second drift region is also called "enhancement region" or "enhancement layer", respectively. The enhancement layer helps to further reduce on state losses.

The enhancement layer around the channel serves to stop injection of second-type charge carriers, e.g. holes, from the bottom side into the first base region. As a consequence, more first-type charge carriers from the top side are injected into the drift region. Hence, the higher the doping concentration in the enhancement layer, the lower the on-state losses. In an IGBT design, a blocking junction is formed between the first base region and n-drift region. During blocking, the thickness of the drift region and resistivity (together with a buffer layer and the collector layer of the second conductivity type at the bottom side) are designed so that the depletion layer does not reach the collector layer which would cause the device to fail. Thus, it does not block, if the enhancement layer doping concentration is too high. When using an enhancement layer, the doping concentration of this layer is preferably low enough so that this layer completely depletes during the off-state, i.e. there is a trade-off between blocking and on-state losses.

Next, the method for producing a semiconductor device is specified. For example, the semiconductor device as specified herein can be produced with this method. Therefore, all features disclosed in connection with the semiconductor device are also disclosed for the method and vice versa.

According to the invention, the method for producing a semiconductor device is defined in claim 11. The method comprises a step in which a semiconductor body with a top side and a bottom side is provided. Then, at least two trenches, namely a first-type trench and a second-type trench, are formed in the semiconductor body, wherein each of the trenches extends from the top side into the semiconductor body. Furthermore, a first main electrode is formed on the top side and a second main electrode is formed on the bottom side of the semiconductor body. A gate electrode is formed such that the gate electrode extends into the first-type trench where it is separated from the semiconductor body by a gate insulation layer. The second-type trench is free of the gate electrode. The semiconductor device is formed such that the semiconductor body comprises a drift region of a first conductivity type arranged vertically between the top side and the bottom side and at least two base regions, namely a first and a second base region, each of a second conductivity type and each arranged vertically between the drift region and the top side. The semiconductor body further comprises an injection region of the first conductivity type, vertically spaced apart from the drift region by the first base region and adjoining the first base region. The first base region, the first-type trench, the second base region and the second-type trench are arranged in this order one after the other in a first lateral direction. The first main electrode is in electrical contact with the injection region. The trenches are formed such that the second-type trench extends deeper into the semiconductor body than the first-type trench.

The trenches may be formed in the semiconductor body before the base regions and the injection region are formed. Alternatively, the base regions may be at least partially formed before the trenches are formed.

According to a further embodiment, the trenches are formed in a common etching step using a common mask. The mask comprises holes in the regions where the trenches are to be formed. The hole for the second-type trench has a greater width than the hole for the first-type trench.

The width of a hole defines the width of the trench. Since the etching depth increases with increasing width (particularly for anisotropic etching processes), the first-type trench and the second-type trench are automatically formed with different depths. Thus, a common etching step can be applied for forming the first-type trenches and the second-type trenches. For example, the following etching processes can be used in order to achieve the automatic formation of trenches with different depths: BOSCH type process (C4F8 passivation step, O2 cleaning step and a SF6 isotropic etch step in consecutive pulsed cycles), other anisotropic dry etch processes like SF6 and C4F8 mixed.

Hereinafter, the semiconductor device and the method for producing a semiconductor device will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.

Figures 1 to 6 show different examples of the semiconductor device in different views which are not covered by the claims but are useful for understanding the invention, Figures 7 to 13 show different exemplary embodiments of the semiconductor device in different views,

Figures 14 to 16 show different positions in an example of the method for producing a semiconductor device, said different positions are not covered by the claims but are useful for understanding the invention,

Figures 17 to 19 show simulations.

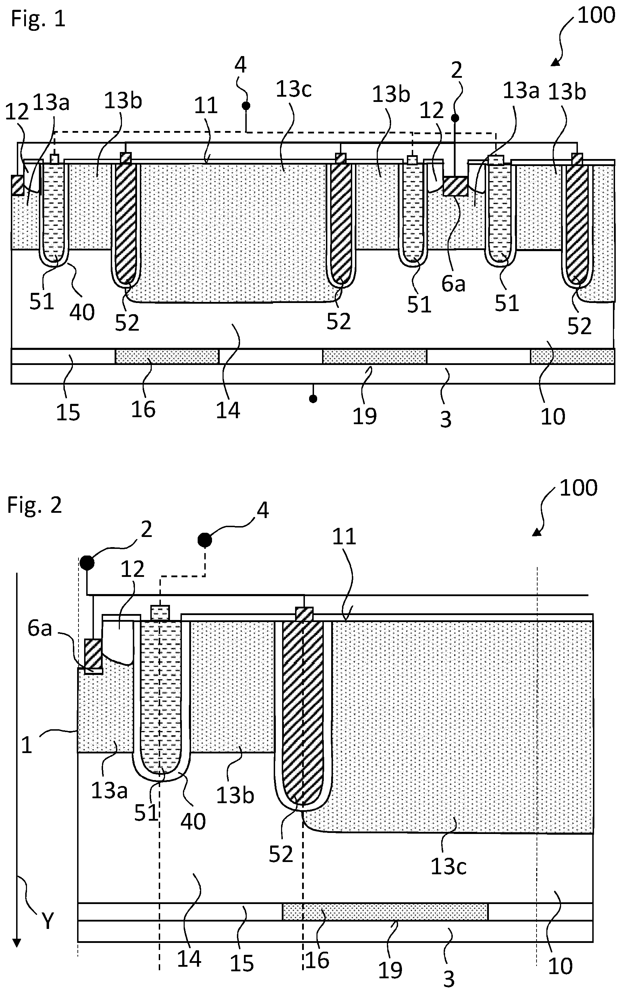

Figure 1 shows a first example of the semiconductor device 100 in a cross-sectional view. The first example is not part of the invention but is useful for understanding it The semiconductor device 100 is, in this case, an RC-IGBT. It comprises a semiconductor body 10 with a top side 11 and a bottom side 19, lying opposite to each other in a vertical direction. The semiconductor body 10 is based on Si or SiC, for example.

At the bottom side 19, the semiconductor body 10 comprises first-type regions 15 and second-type regions 16, which are arranged in an alternating manner. The regions 15 and 16 are in electrical contact with a second main electrode 3, namely a collector electrode 3, on the bottom side 19. The collector electrode 3 is, for example, formed of metal.

The first-type regions 15 are of a first conductivity type, which is n-type in the following, and the second-type regions 16 are of a second conductivity type, which is p-type in the following. A drift region 14 is arranged between the top side 11 and the bottom side 19. The drift region 14 is of the first conductivity type, i.e. n-type. The drift region 14 adjoins the first-type 15 and the second-type 16 regions.

A plurality of trenches 51, 52 extend from the top side into the semiconductor body 10 and into the drift region 14. The trenches 51 are first-type trenches, herein also called "active trenches", and the trenches 52 are second-type trenches, herein also called "inactive trenches" or "dummy trenches".

The first-type trenches 51 are filled with an electrically conductive material which is electrically separated from the semiconductor body 10 by an electrically insulating layer 40, herein called "gate insulation layer". Thus, there is no direct electrical contact between the semiconductor body 10 and the electrically conductive material in the first-type trenches 51. The gate insulation layer 40 is, for example, formed of an oxide, like SiO₂. The electrically conductive material in the first-type trenches 51 may be a highly-doped polysilicon. The electrically conductive material in the first-type trenches 51 is part of a gate electrode 4 of the semiconductor device 100.

The second-type trenches 52 are also filled with electrically conductive material, e.g. highly-doped polysilicon, which is also electrically separated from the semiconductor body 10 by an electrically insulating layer which is the same as the gate insulation layer 40. The electrically conductive material in the second-type trenches 52 is part of a first main electrode 2, namely an emitter electrode 2, arranged on the top side 12. The first base regions 13a adjoin and are in electrical contact with the emitter electrode 2 in first contact areas 6a, also called "Rb-prime areas".

The semiconductor body 10 comprises several base regions 13a, 13b, 13c, which are arranged vertically between the drift region 14 and the top side 11. The base regions 13a, 13b, 13c are all of the second conductivity type, i.e. p-type, and they all adjoin the drift region 14 as well as the top side 11. First 13a and second 13b base regions are shallower (smaller vertical extension) than the trenches 51, 52. The third base region 13c is deeper than the trenches 51, 52, i.e. extends further into the semiconductor body 10.

As can be seen in figure 1, the semiconductor device 100 is subdivided into a plurality of so-called half-cells. One such half-cell is shown in greater detail in figure 2. The half-cell is the structure between the vertical dashed lines in figure 2. In figure 1, several such half-cells are arranged one after the other in a first lateral direction, running from the left to the right. Two adjacent half-cells are mirrored with respect to each other at the plane running perpendicularly to the first lateral direction and through the third base region 13c (see right vertical dashed line in figure 2).

As can be seen in figure 2, the half-cell comprises a portion (half) of a first base region 13c, a first-type trench 51, a second base region 13b, a second-type trench 52 and a portion (half) of a third base region 13c which are arranged one after the other in this order along the first lateral direction. The half-cell further comprises an injection region 12 (source region 12) of the first conductivity type, i.e. n-type, arranged vertically between the first base region 13c and the top side 11. The injection region 12 adjoins the first base region 13c and the first-type trench 51. The injection region 12 further adjoins the emitter electrode 2 and is in electrical contact therewith.

The operation of the semiconductor device may be as follows:
In a so-called transistor mode, the emitter electrode 2 is set to ground and the collector electrode 3 is set to a positive potential. The gate electrode 4 is set to a positive potential so that the first base region 13a is depleted at the border to the first-type trench 51. A conduction path is created in the first base region 13c along the first-type trench 51. Electrons can then be injected from the emitter electrode 2 into the injection region 12, can travel along the conduction path, and reach into the drift region 14. On the bottom side 19, holes are injected from the collector electrode 3 via the second-type regions 16 and also travel into the drift region 14 so that an electron-hole plasma is created.

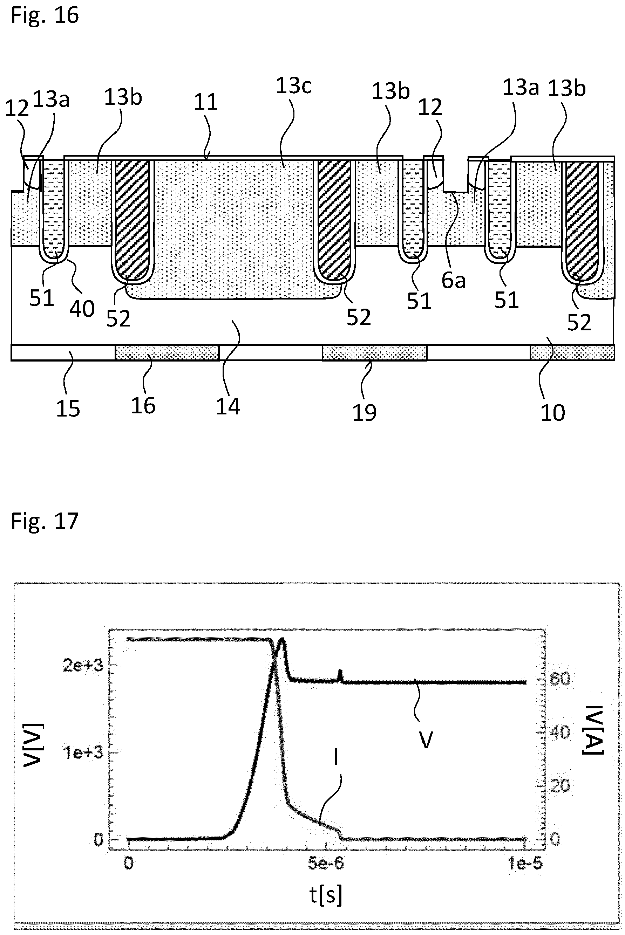

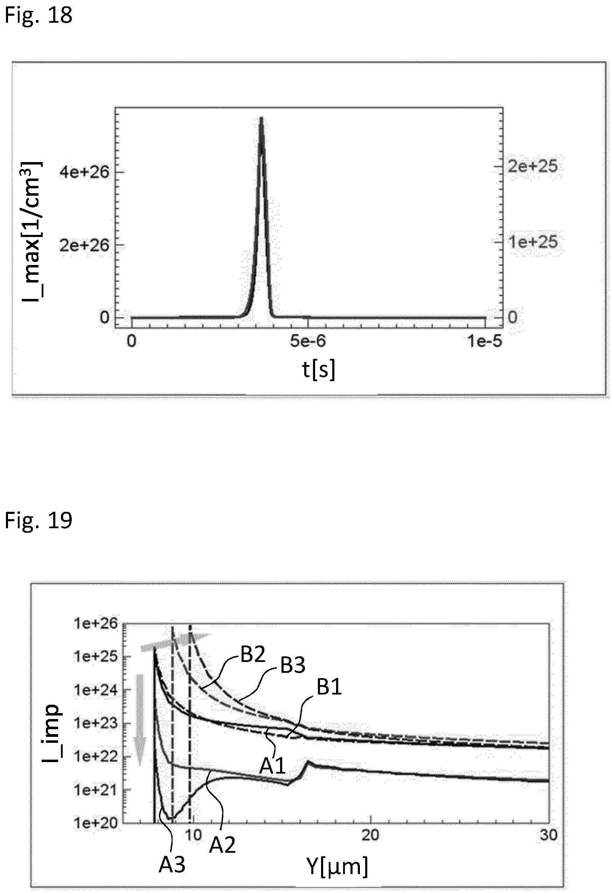

When turning off of the transistor mode, the electron-hole plasma can create avalanches in the region of the first-type trench 51. Figure 17 shows simulations of the current I and the voltage V as a function of time t during turning off from the transistor mode. Figure 18 shows the corresponding simulated maximum avalanche generation I_max as a function of time t. Indeed, during turnoff, there is a very high intensity of avalanches.

Such avalanches can harm the gate insulation layer 40 so that the long-term performance stability of the semiconductor device 10 is negatively affected. It has been found that the second-type, inactive trench 52 and the third base region 13c extending deeper into the semiconductor body than the trenches 51, 52, help to divert avalanches away from the active trench 51.

This effect is additionally increased by the second-type trench 52 extending deeper into the semiconductor body, i.e. having a greater vertical extension, than the first-type trench 51. For example, the depth of the second-type trench 52 is at least 0.5 µm greater than the depth of the first-type trench 51.

Figure 19 shows simulations of the impact ionization along the cross-sections indicated by the vertical dashed lines in figure 2. The solid curves A1, A2 and A3 show the impact ionization as a function of the depth Y along the first-type trench 51 and the dashed curves B1, B2, B3 show the impact ionization as a function of the depth Y along the second-type trench 52.

The curves A1 and B1 show simulation results for equal depths of the first-type trench 51 and the second-type trench 52. The curves A2 and B2 show simulation results for a second-type trench 52 being 1 µm deeper than the first-type trench 51. The curves A3 and B3 show simulation results for the second-type trench 52 being 2 µm deeper than the first-type trench 51.

As can be seen, when the trenches 51, 52 have the same depths, both trenches share the same level of impact ionization. With the second-type trench 52 becoming deeper than the first-type trench 51, the stress on the gate insulation layer 40 in the first-type trench 51 is greatly reduced. The peak of impact ionization at the bottom of the first-type trench 51 is reduced by more than one order of magnitude with a second-type trench 52 which is 1 µm deeper than the first-type trench 51 and by more than two orders of magnitude with a second-type trench 52 which is 2 µm deeper than the first-type trench 51.

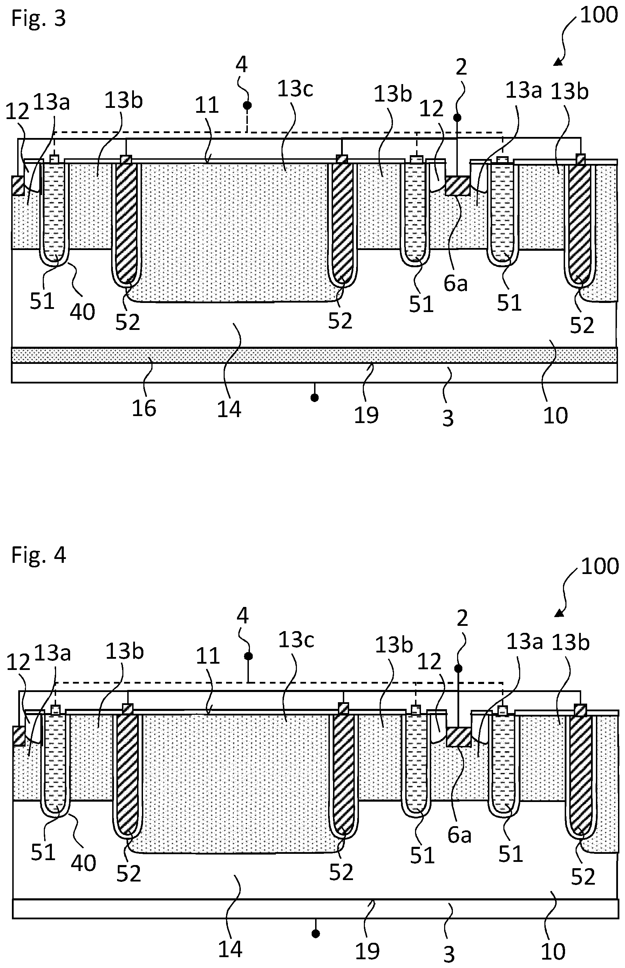

Figure 3 shows a further example of the semiconductor device 100 which, in this case, is an IGBT. At the top side 11, the semiconductor device 100 is identical to the semiconductor device of figure 1. The bottom side 19, however, is only formed by the second-type region 16 (collector layer 16) being of the second conductivity type.

Figure 4 shows an example of the semiconductor device 100 which is a MISFET. Also here, the top side 11 is the same as in figures 1 and 3. The bottom side 19, however, is only formed by n-type semiconductor material.

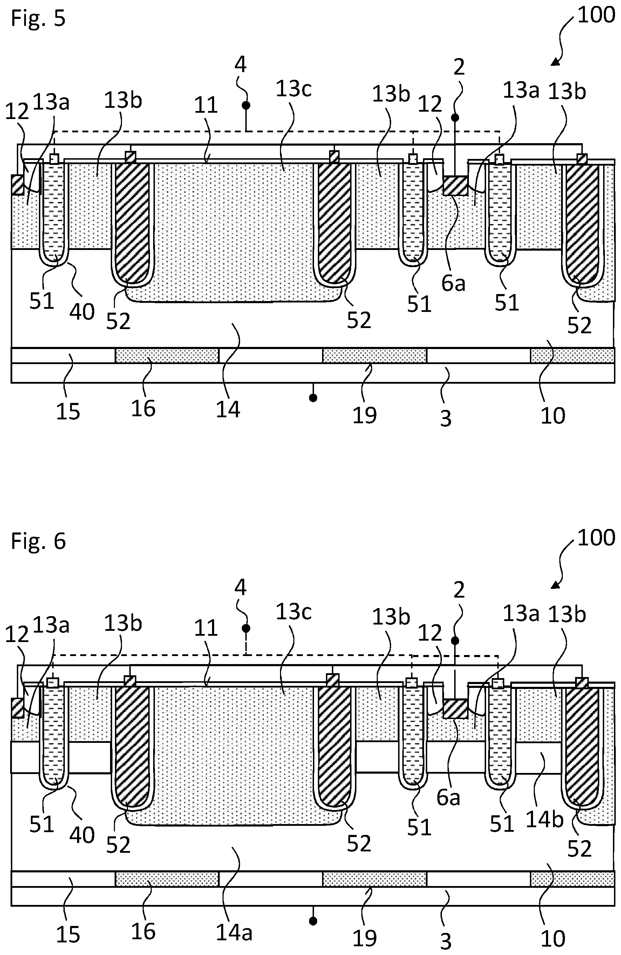

In the example of the semiconductor device 100 of figure 5, not only the depths of the second-type trenches 52 are greater than of the first-type trenches 51, but also the widths measured in the first lateral direction are greater. Trenches with different depths and, at the same time, different widths can be produced particularly easily.

Another example of the semiconductor device 100 is shown in figure 6. In this case, the drift region 14 comprises a first drift region 14a and a second drift region 14b. The second drift region 14b is arranged between the first drift region 14a and the base regions 13a, 13b, 13c in vertical direction and adjoins the base regions. The trenches 51, 52 extend vertically beyond the second drift region 14b and end in the first drift region 14a. In the second drift region 14b, the doping concentration with n-type dopants is greater than in the first drift region 14a, e.g. by a factor of at least 10 or at least 100. Such a second drift region 14b, also called "enhancement region" or "enhancement layer", helps to improve on-state losses.

The examples of figures 3 to 6 are not part of the invention but are useful for understanding it.

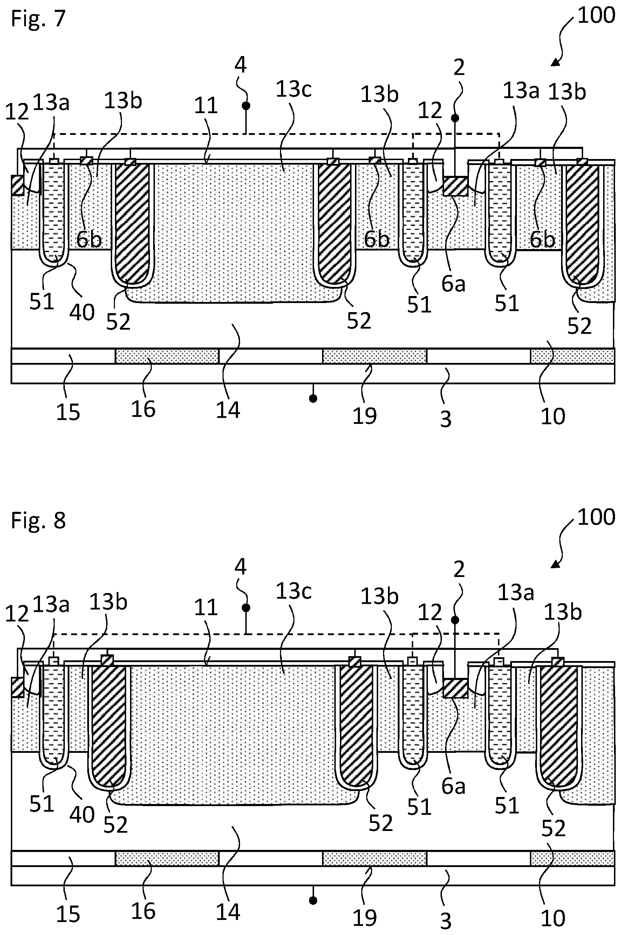

Figure 7 to 9 show an exemplary embodiment of the semiconductor device 100 in different views, according to the present invention. Here, the second base regions 13b each comprise second contact areas 6b in which the second base regions 13b are in electrical contact with the first main electrode 2. During turn-off of the transistor mode, at least a part of the plasma can be extracted via these contact areas 6b so that the charge carriers are effectively diverted away from the first-type trench 51. As a consequence, the avalanche generation near the first-type trench 51 is further reduced.

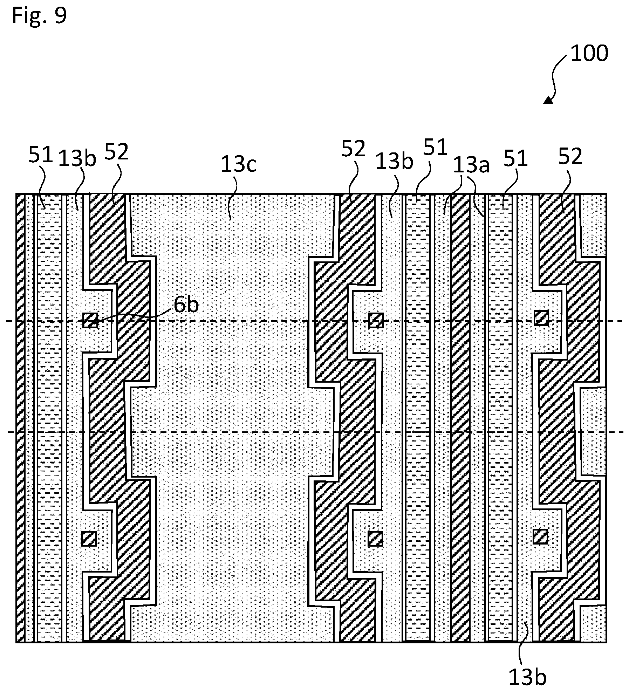

Figure 9 shows the semiconductor device 100 of figure 7 in top view onto the top side 11. The upper horizontal dashed line indicates the cross sectional plane for the cross-sectional view of figure 7. The lower horizontal dashed line indicates the cross-sectional plane for the cross-sectional view of figure 8.

As can be seen in figure 9, the second-type trenches 52 each follow a rectangular function when moving along the second lateral direction. The second lateral direction is from down to up in figure 9. In each of the rectangles, the distance between the second-type trench 52 and the adjacent first-type trench 51, measured in the first lateral direction, has a maximum value. Within each of the rectangles, a contact area 6b is arranged, in which the respective second base region 13b is in electrical contact with the first main electrode 2. In regions where no contact areas are located in the second base regions 13b, the distance between the first-type trench 51 and the adjacent second-type trench 52 reaches a minimum value. For example, this minimum value is smaller than the widths of the second-type trenches 52, e.g. is at most 200 nm.

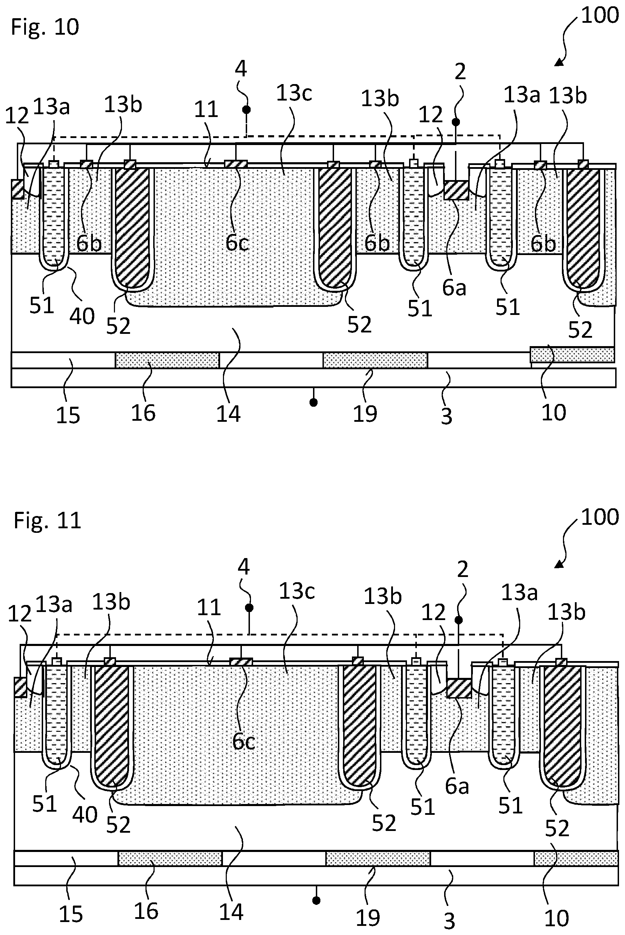

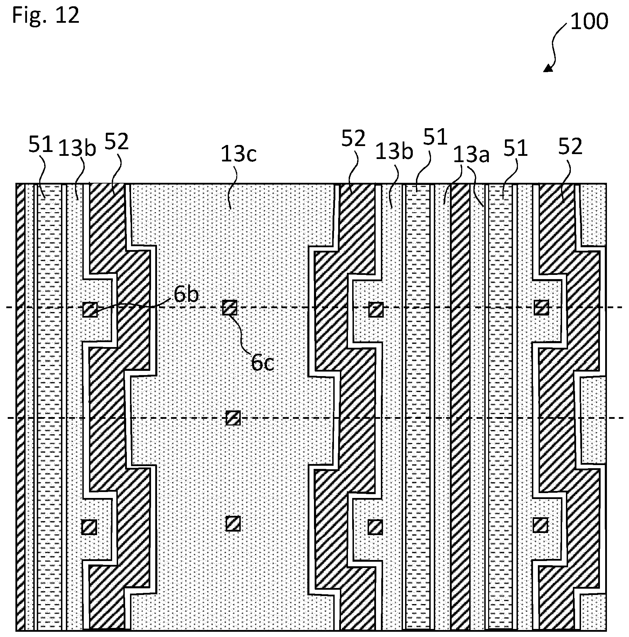

Figures 10 to 12 show a further exemplary embodiment of the semiconductor device 100 in the same views as explained in connection with figures 7 to 9. Also the third base regions 13c comprise contact areas 6c in which the third base regions 13c are in electrical contact with first main electrode 2. Also these contact areas 6c can help to divert the plasma away from the first-type trenches 51 during turn-off of the transistor mode.

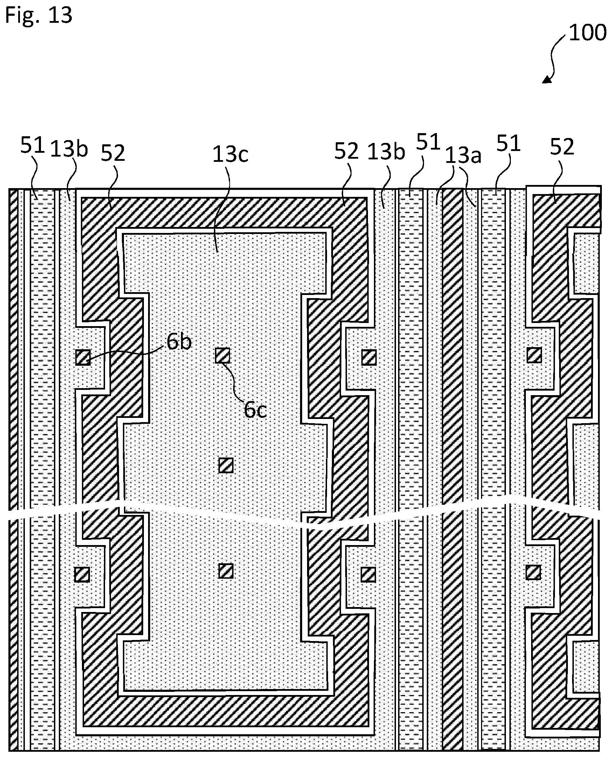

Figure 13 shows a further exemplary embodiment of the semiconductor device 100, now only in top view onto the top side 11 of the semiconductor body 10. As can be seen here, the second-type trenches 52 sandwiching the third base region 13c in the first lateral direction are actually connected at their respective longitudinal ends so that a contiguous trench completely surrounds the first base region 13c.

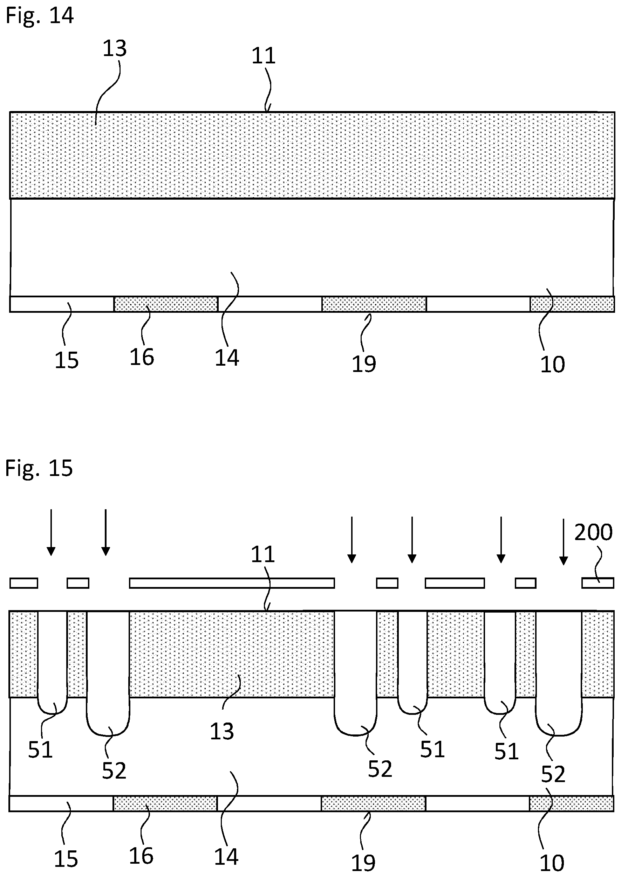

Figure 14 shows a first position in an example of the method for producing a semiconductor device 100. In this position, a semiconductor body 10 with a top side 11 and a bottom side 19 is provided. The bottom side 19 is formed by first-type regions 15 and second-type regions 16 arranged in an alternating manner. The top side 11 is formed by a base region 13 being of the second conductivity type. A drift region 14 is arranged between the bottom side 19 and the base region 13, wherein the drift region 14 is of the first conductivity type.

Figure 15 shows a position in which trenches are formed in the semiconductor body 10 by etching into the top side 11. The trenches are formed with the help of a mask 200 which comprises a plurality of holes in the regions where the trenches are to be formed. The holes for the second-type trenches 52 have a greater width than the holes for the first-type trenches 51. Due to this, the trenches are formed with different widths but at the same time also with different depths.

Figure 16 shows a position after the trenches 51, 52 have been filled with electrically conductive material. The electrically conductive material in the trenches 51, 52 is electrically separated from the semiconductor body 10 by electrically isolating material 40 arranged in the trenches 51, 52. Moreover, first base regions 13a, second base regions 13b and third base regions 13c have been formed, e.g. by ion implantation. Also injection regions 12 have been formed in the semiconductor body 10, e.g. by means of ion implantation.

The examples of positions as shown in figures 14 to 16 are not part of the invention but are useful for understanding it.

### Reference Signs

- 2: first main electrode
- 3: second main electrode
- 4: gate electrode
- 5: further electrode
- 6a: first contact area
- 6b: second contact area
- 6c: third contact area
- 10: semiconductor body
- 11: top side
- 12: injection region
- 13: base region
- 13a: first base region
- 13b: second base region
- 13c: third base region
- 14: drift region
- 14a: first drift region
- 14b: second drift region
- 15: first-type region
- 16: second-type region
- 19: bottom side
- 40: electrically insulating layer / gate insulation layer
- 51: first-type trench
- 52: second-type trench
- 100: semiconductor device
- 200: mask
- A1 to A3: curves
- B1 to B3: curves

## Claims

1. Semiconductor device (100) comprising
- a semiconductor body (10) extending in vertical direction between a top side (11) and a bottom side (19),
- a first main electrode (2) on the top side (11) and a second main electrode (3) on the bottom side (19),
- a gate electrode (4),
- at least two trenches, namely a first-type trench (51) and a second-type trench (52), each extending from the top side (11) into the semiconductor body (10), wherein
- the semiconductor body (10) comprises
- a drift region (14) of a first conductivity type vertically between the top side (11) and the bottom side (19),
- at least two base regions, namely a first (13a) and a second (13b) base region, each of a second conductivity type and each arranged vertically between the drift region (14) and the top side (11),
- an injection region (12) of the first conductivity type vertically spaced apart from the drift region (14) by the first base region (13a) and adjoining the first base region (13a),
- the first base region (13a), the first-type trench (51), the second base region (13b) and the second-type trench (52) are arranged in this order one after the other in a first lateral direction,
- the first main electrode (2) is in electrical contact with the injection region (12),
- the gate electrode (4) extends into the first-type trench (51) where it is separated from the semiconductor body (10) by a gate insulation layer (40),
- the second-type trench (52) is free of the gate electrode (4),
- the second base region (13b) comprises a plurality of laterally spaced contact areas (6b), wherein the second base region (13b) is in electrical contact with the first main electrode (2) in each of these contact areas (6b),
- the contact areas (6b) in the second base region (13b) are spaced apart from each other in a second lateral direction which is perpendicular to the first lateral direction,
**characterized in that**
- the distance between the first-type trench (51) and the second-type trench (52) measured in the first lateral direction varies when moving along the second lateral direction,
- the distance between the first-type trench (51) and the second-type trench (52) is greater where a contact area (6b) is arranged between them and smaller where no contact area is arranged between them, and
further **characterized in that**
- the second-type trench (52) extends deeper into the semiconductor body (10) than the first-type trench (51).

2. Semiconductor device (100) according to claim 1, wherein
- a width of the second-type trench (52) is greater than a width of the first-type trench (51).

3. Semiconductor device (100) according to claim 1 or 2, wherein
- a minimal distance between the first-type trench (51) and the second-type trench (52), measured in the first lateral direction, is at most 2-times the width of the second-type trench (52).

4. Semiconductor device (100) according to claim 1 or 2, wherein
- the first main electrode (2) extends into the second-type trench (52) where it is separated from the semiconductor body (10) by an electrically insulating layer (40).

5. Semiconductor device (100) according to any one of the preceding claims, wherein
- the second-type trench (52) is arranged between two first-type trenches (51) in the first lateral direction.

6. Semiconductor device (100) according to claim 5, wherein
- two second-type trenches (52) are arranged between the two first-type trenches (51) in the first lateral direction.

7. Semiconductor device (100) according to any one of the preceding claims, wherein
- the second-type trench (52) is arranged between the second base region (13b) and a third base region (13c) in the first lateral direction, wherein the third base region (13c) is of the second conductivity type,
- the third base region (13c) extends deeper into the semiconductor body (10) than the second-type trench (52).

8. Semiconductor device (100) according to claims 6 and **7,** wherein
- the third base region (13c) is arranged between the two second-type trenches (52) in the first lateral direction,
- the third base region (13c) adjoins the two second-type trenches (52),
- the two second-type trenches (52) are connected with each other at their respective longitudinal ends so that, in top view onto the top side (11), the third base region (13c) is completely surrounded by a contiguous trench.

9. Semiconductor device (100) according to claim 7, wherein
- the third base region (13c) comprises at least one contact area (6c) in which the third base region (13c) is in electrical contact with the first main electrode (2).

10. Semiconductor device (100) according to any one of the preceding claims, wherein
- the drift region (14) comprises a first drift region (14a) and a second drift region (14b) arranged one after the other in vertical direction,
- the second drift region (14b) is arranged vertically between the first drift region (14a) and the first base region (13a),
- the second drift region (14b) has a greater doping concentration than the first drift region (14a).

11. Method for producing a semiconductor device (100), comprising
- providing a semiconductor body (10) with a top side (11) and a bottom side (19),
- forming at least two trenches, namely a first-type trench (51) and a second-type trench (52), each one extending from the top side (11) into the semiconductor body (10),
- forming a first main electrode (2) on the top side (11) and a second main electrode (3) on the bottom side (19),
- forming a gate electrode (4) such that the gate electrode (4) extends into the first-type trench (51) where it is separated from the semiconductor body (10) by a gate insulation layer (40), wherein
- the second-type trench (52) is kept free of the gate electrode (4),
- the semiconductor device (100) is formed such that the semiconductor body (10) comprises
- a drift region (14) of a first conductivity type vertically between the top side (11) and the bottom side (19),
- at least two base regions, namely a first (13a) and a second (13b) base region, each of a second conductivity type and each arranged vertically between the drift region (14) and the top side (11),
- an injection region (12) of the first conductivity type, vertically spaced apart from the drift region (14) by the first base region (13a) and adjoining the first base region (13a),
- the first base region (13a), the first-type trench (51), the second base region (13b) and the second-type trench (52) are arranged in this order one after the other in a first lateral direction,
- the first main electrode (2) is in electrical contact with the injection region (12),
- the second base region (13b) comprises a plurality of laterally spaced contact areas (6b), wherein the second base region (13b) is in electrical contact with the first main electrode (2) in each of these contact areas (6b),
- the contact areas (6b) in the second base region (13b) are spaced apart from each other in a second lateral direction which is perpendicular to the first lateral direction,
**characterized in that**
- the distance between the first-type trench (51) and the second-type trench (52) measured in the first lateral direction varies when moving along the second lateral direction,
- the distance between the first-type trench (51) and the second-type trench is greater where a contact area (6b) is arranged between them and smaller where no contact area is arranged between them, and
further **characterized in that**
- the trenches (51, 52) are formed such that the second-type trench (52) extends deeper into the semiconductor body (10) than the first-type trench (51).

12. Method according to claim 11, wherein
- the trenches (51, 52) are formed in a common etching step using a common mask (200),
- the mask (200) comprises holes in the regions where the trenches (51, 52) are to be formed,
- the hole for the second-type trench (52) has a greater width than the hole for the first-type-trench (51).

## Patentansprüche

1. Halbleiterbauelement (100), umfassend
- einen Halbleiterbody (10), der sich in vertikaler Richtung zwischen einer ersten Oberseite (11) und einer Unterseite (19) erstreckt,
- eine erste Hauptelektrode (2) auf der Oberseite (11) und eine zweite Hauptelektrode (3) auf der Unterseite (19),
- eine Gate-Elektrode (4),
- mindestens zwei Gräben, nämlich einen Graben eines ersten Typs (51) und einen Graben eines zweiten Typs (52), die sich jeweils von der Oberseite (11) in den Halbleiterbody (10) erstrecken, wobei
- der Halbleiterbody (10) Folgendes umfasst:
- ein Driftgebiet (14) eines ersten Leitfähigkeitstyps vertikal zwischen der Oberseite (11) und der Unterseite (19),
- mindestens zwei Basisgebiete, nämlich ein erstes (13a) und ein zweites (13b) Basisgebiet, die jeweils von einem zweiten Leitfähigkeitstyp und jeweils vertikal zwischen dem Driftgebiet (14) und der Oberseite (11) angeordnet sind,
- ein Injektionsgebiet (12) des ersten Leitfähigkeitstyps, das durch das erste Basisgebiet (13a) vertikal von dem Driftgebiet (14) beabstandet ist und an das erste Basisgebiet (13a) angrenzt,
- das erste Basisgebiet (13a), der Graben (51) des ersten Typs, das zweite Basisgebiet (13b) und der Graben (52) des zweiten Typs in einer ersten seitlichen Richtung in dieser Reihenfolge hintereinander angeordnet sind,
- die erste Hauptelektrode (2) in elektrischem Kontakt mit dem Injektionsgebiet (12) steht,
- die Gate-Elektrode (4) sich in den Graben (51) des ersten Typs erstreckt, wo sie durch eine Gate-Isolationsschicht (40) von dem Halbleiterbody (10) getrennt ist,
- der Graben (52) des zweiten Typs frei von der Gate-Elektrode (4) ist,
- das zweite Basisgebiet (13b) eine Mehrzahl von seitlich beabstandeten Kontaktbereichen (6b) umfasst, wobei das zweite Basisgebiet (13b) in jedem dieser Kontaktbereiche (6b) in elektrischem Kontakt mit der ersten Hauptelektrode (2) steht,
- die Kontaktbereiche (6b) in dem zweiten Basisgebiet (13b) in einer zweiten seitlichen Richtung, die senkrecht zu der ersten seitlichen Richtung ist, voneinander beabstandet sind,
**dadurch gekennzeichnet, dass**
- der Abstand zwischen dem Graben (51) des ersten Typs und dem Graben (52) des zweiten Typs, gemessen in der ersten seitlichen Richtung, bei Bewegung entlang der zweiten seitlichen Richtung variiert,
- der Abstand zwischen dem Graben (51) des ersten Typs und dem Graben (52) des zweiten Typs dort, wo ein Kontaktbereich (6b) zwischen ihnen angeordnet ist, größer und dort, wo kein Kontaktbereich zwischen ihnen angeordnet ist, kleiner ist, und
ferner **dadurch gekennzeichnet, dass**
- der Graben (52) des zweiten Typs sich tiefer in den Halbleiterbody (10) erstreckt als der Graben (51) des ersten Typs.

2. Halbleitervorrichtung (100) nach Anspruch 1, wobei
- eine Breite des Grabens (52) des zweiten Typs größer ist als eine Breite des Grabens (51) des ersten Typs.

3. Halbleiterbauelement (100) nach Anspruch 1 oder 2, wobei
- ein Mindestabstand zwischen dem Graben (51) des ersten Typs und dem Graben (52) des zweiten Typs, gemessen in der ersten seitlichen Richtung, höchstens das 2-Fache der Breite des Grabens (52) des zweiten Typs beträgt.

4. Halbleiterbauelement (100) nach Anspruch 1 oder 2, wobei
- die erste Hauptelektrode (2) sich in den Graben (52) des zweiten Typs erstreckt, wo sie durch eine elektrisch isolierende Schicht (40) von dem Halbleiterbody (10) getrennt ist.

5. Halbleiterbauelement (100) nach einem der vorhergehenden Ansprüche, wobei
- der Graben (52) des zweiten Typs in der ersten seitlichen Richtung zwischen zwei Gräben (51) des ersten Typs angeordnet ist.

6. Halbleitervorrichtung (100) nach Anspruch 5, wobei
- zwei Gräben (52) des zweiten Typs in der ersten seitlichen Richtung zwischen den zwei Gräben (51) des ersten Typs angeordnet sind.

7. Halbleiterbauelement (100) nach einem der vorhergehenden Ansprüche, wobei
- der Graben (52) des zweiten Typs in der ersten seitlichen Richtung zwischen dem zweiten Basisgebiet (13b) und einem dritten Basisgebiet (13c) angeordnet ist, wobei das dritte Basisgebiet (13c) vom zweiten Leitfähigkeitstyp ist,
- das dritte Basisgebiet (13c) sich tiefer in den Halbleiterbody (10) erstreckt als der Graben (52) des zweiten Typs.

8. Halbleiterbauelement (100) nach Anspruch 6 oder 7, wobei
- das dritte Basisgebiet (13c) in der ersten seitlichen Richtung zwischen den zwei Gräben des zweiten Typs (52) angeordnet ist,
- das dritte Basisgebiet (13c) an die zwei Gräben (52) des zweiten Typs angrenzt,
- die zwei Gräben (52) des zweiten Typs an ihren jeweiligen Längsenden miteinander verbunden sind, so dass in Draufsicht auf die Oberseite (11) das dritte Basisgebiet (13c) vollständig von einem benachbarten Graben umgeben ist.

9. Halbleitervorrichtung (100) nach Anspruch 7, wobei
- das dritte Basisgebiet (13c) mindestens einen Kontaktbereich (6c) umfasst, in dem das dritte Basisgebiet (13c) in elektrischem Kontakt mit der ersten Hauptelektrode (2) steht.

10. Halbleiterbauelement (100) nach einem der vorhergehenden Ansprüche, wobei
- das Driftgebiet (14) ein erstes Driftgebiet (14a) und ein zweites Driftgebiet (14b) umfasst, die in vertikaler Richtung hintereinander angeordnet sind,
- das zweite Driftgebiet (14b) vertikal zwischen dem ersten Driftgebiet (14a) und dem ersten Basisgebiet (13a) angeordnet ist,
- das zweite Driftgebiet (14b) eine höhere Dotierungskonzentration als das erste Driftgebiet (14a) aufweist.

11. Verfahren zur Herstellung eines Halbleiterbauelements (100), umfassend
- Bereitstellen eines Halbleiterbodys (10) mit einer Oberseite (11) und einer Unterseite (19),
- Bilden mindestens zweier Gräben, nämlich eines Grabens (51) von einem ersten Typ und eines Grabens (52) von einem zweiten Typ, die sich jeweils von der Oberseite (11) in den Halbleiterbody (10) erstrecken,
- Bilden einer ersten Hauptelektrode (2) auf der Oberseite (11) und einer zweiten Hauptelektrode (3) auf der Unterseite (19),
- Bilden einer Gate-Elektrode (4), so dass sich die Gate-Elektrode (4) in den Graben (51) des ersten Typs erstreckt, wo sie durch eine Gate-Isolationsschicht (40) von dem Halbleiterbody (10) getrennt ist, wobei
- der Graben (52) des zweiten Typs von der Gate-Elektrode (4) freigehalten wird,
- die Halbleitervorrichtung (100) so gebildet wird, dass der Halbleiterbody (10) Folgendes umfasst:
- ein Driftgebiet (14) eines ersten Leitfähigkeitstyps vertikal zwischen der Oberseite (11) und der Unterseite (19),
- mindestens zwei Basisgebiete, nämlich ein erstes (13a) und ein zweites (13b) Basisgebiet, die jeweils von einem zweiten Leitfähigkeitstyp und jeweils vertikal zwischen dem Driftgebiet (14) und der Oberseite (11) angeordnet sind,
- ein Injektionsgebiet (12) des ersten Leitfähigkeitstyps, das durch das erste Basisgebiet (13a) vertikal von dem Driftgebiet (14) beabstandet ist und an das erste Basisgebiet (13a) angrenzt,
- das erste Basisgebiet (13a), der Graben (51) des ersten Typs, das zweite Basisgebiet (13b) und der Graben (52) des zweiten Typs in einer ersten seitlichen Richtung in dieser Reihenfolge hintereinander angeordnet sind,
- die erste Hauptelektrode (2) in elektrischem Kontakt mit dem Injektionsgebiet (12) steht,
- das zweite Basisgebiet (13b) eine Mehrzahl von seitlich beabstandeten Kontaktbereichen (6b) umfasst, wobei das zweite Basisgebiet (13b) in jedem dieser Kontaktbereiche (6b) in elektrischem Kontakt mit der ersten Hauptelektrode (2) steht,
- die Kontaktbereiche (6b) in dem zweiten Basisgebiet (13b) in einer zweiten seitlichen Richtung, die senkrecht zu der ersten seitlichen Richtung ist, voneinander beabstandet sind,
**dadurch gekennzeichnet, dass**
- der Abstand zwischen dem Graben (51) des ersten Typs und dem Graben (52) des zweiten Typs, gemessen in der ersten seitlichen Richtung, bei Bewegung entlang der zweiten seitlichen Richtung variiert,
- der Abstand zwischen dem Graben (51) des ersten Typs und dem Graben des zweiten Typs dort, wo ein Kontaktbereich (6b) zwischen ihnen angeordnet ist, größer und dort, wo kein Kontaktbereich zwischen ihnen angeordnet ist, kleiner ist, und
ferner **dadurch gekennzeichnet, dass**
- die Gräben (51, 52) so gebildet werden, dass sich der Graben (52) des zweiten Typs tiefer in den Halbleiterbody (10) erstreckt als der Graben (51) des ersten Typs.

12. Verfahren nach Anspruch 11, wobei
- die Gräben (51, 52) in einem gemeinsamen Ätzschritt unter Verwendung einer gemeinsamen Maske (200) gebildet werden,
- die Maske (200) Löcher in den Gebieten umfasst, wo die Gräben (51, 52) gebildet werden sollen,
- das Loch für den Graben (52) des zweiten Typs eine größere Breite aufweist als das Loch für den Graben (51) des ersten Typs.

## Revendications

1. Dispositif semi-conducteur (100) comprenant
- un corps semi-conducteur (10) s'étendant dans une direction verticale entre une surface de dessus (11) et une surface de dessous (19),
- une première électrode principale (2) sur le côté de dessus (11) et une deuxième électrode principale (3) sur le côté de dessous (19),
- une électrode grille (4),
- au moins deux tranchées, à savoir une tranchée de premier type (51) et une tranchée de deuxième type (52), s'étendant chacune depuis le côté de dessus (11) jusque dans le corps semi-conducteur (10), dans lequel
- le corps semi-conducteur (10) comprend
- une région de dérive (14) d'un premier type de conductivité verticalement entre le côté de dessus (11) et le côté de dessous (19),
- au moins deux régions de base, à savoir une première (13a) et une deuxième (13b) région de base, chacune d'un deuxième type de conductivité et chacune agencée verticalement entre la région de dérive (14) et le côté de dessus (11),
- une région d'injection (12) du premier type de conductivité espacée verticalement de la région de dérive (14) par la première région de base (13a) et attenante à la première région de base (13a),
- la première région de base (13a), la tranchée de premier type (51), la deuxième région de base (13b) et la tranchée de deuxième type (52) sont agencées dans cet ordre l'une après l'autre dans une première direction latérale,
- la première électrode principale (2) est en contact électrique avec la zone d'injection (12),
- l'électrode grille (4) s'étend jusque dans la tranchée de premier type (51) où elle est séparée du corps semi-conducteur (10) par une couche d'isolation de grille (40),
- la tranchée de deuxième type (52) est dépourvue de l'électrode grille (4),
- la deuxième région de base (13b) comprend une pluralité de zones de contact (6b) espacées latéralement, la deuxième région de base (13b) étant en contact électrique avec la première électrode principale (2) dans chacune de ces zones de contact (6b),
- les zones de contact (6b) dans la deuxième région de base (13b) sont espacées l'une de l'autre dans une deuxième direction latérale qui est perpendiculaire à la première direction latérale,
**caractérisé en ce que**
- la distance entre la tranchée de premier type (51) et la tranchée de deuxième type (52) mesurée dans la première direction latérale varie lors d'un déplacement le long de la deuxième direction latérale,
- la distance entre la tranchée de premier type (51) et la tranchée de deuxième type (52) est plus grande là où une zone de contact (6b) est agencée entre elles et plus petite là où aucune zone de contact n'est agencée entre elles, et
en outre **caractérisé en ce que**
- la tranchée de deuxième type (52) s'étend plus profondément dans le corps semi-conducteur (10) que la tranchée de premier type (51).

2. Dispositif semi-conducteur (100) selon la revendication 1, dans lequel
- une largeur de la tranchée de deuxième type (52) est plus grande qu'une largeur de la tranchée de premier type (51).

3. Dispositif semi-conducteur (100) selon la revendication 1 ou la revendication 2, dans lequel
- une distance minimale entre la tranchée de premier type (51) et la tranchée de deuxième type (52), mesurée dans la première direction latérale, fait au plus de 2 fois la largeur de la tranchée de deuxième type (52).

4. Dispositif semi-conducteur (100) selon la revendication 1 ou la revendication 2, dans lequel
- la première électrode principale (2) s'étend jusque dans la tranchée de deuxième type (52) où elle est séparée du corps semi-conducteur (10) par une couche électriquement isolante (40).

5. Dispositif semi-conducteur (100) selon l'une quelconque des revendications précédentes, dans lequel
- la tranchée de deuxième type (52) est agencée entre deux tranchées de premier type (51) dans la première direction latérale.

6. Dispositif semi-conducteur (100) selon la revendication 5, dans lequel
- deux tranchées de deuxième type (52) sont agencées entre les deux tranchées de premier type (51) dans la première direction latérale.

7. Dispositif semi-conducteur (100) selon l'une quelconque des revendications précédentes, dans lequel
- la tranchée de deuxième type (52) est agencée entre la deuxième région de base (13b) et une troisième région de base (13c) dans la première direction latérale, la troisième région de base (13c) étant du deuxième type de conductivité,
- la troisième région de base (13c) s'étend plus profondément dans le corps semi-conducteur (10) que la tranchée de deuxième type (52).

8. Dispositif semi-conducteur (100) selon la revendication 6 ou la revendication 7, dans lequel
- la troisième région de base (13c) est agencée entre les deux tranchées de deuxième type (52) dans la première direction latérale,
- la troisième région de base (13c) est attenante aux deux tranchées de deuxième type (52),
- les deux tranchées de deuxième type (52) sont reliées l'une à l'autre au niveau de leurs extrémités longitudinales respectives de sorte que, en vue de dessus sur le côté de dessus (11), la troisième région de base (13c) soit complètement entourée par une tranchée contiguë.

9. Dispositif semi-conducteur (100) selon la revendication 7, dans lequel
- la troisième région de base (13c) comprend au moins une zone de contact (6c) dans laquelle la troisième région de base (13c) est en contact électrique avec la première électrode principale (2).

10. Dispositif semi-conducteur (100) selon l'une quelconque des revendications précédentes, dans lequel
- la région de dérive (14) comprend une première région de dérive (14a) et une deuxième région de dérive (14b) agencées l'une après l'autre dans la direction verticale,
- la deuxième région de dérive (14b) est agencée verticalement entre la première région de dérive (14a) et la première région de base (13a),
- la deuxième région de dérive (14b) a une plus grande concentration de dopants que la première région de dérive (14a).

11. Procédé de production d'un dispositif semi-conducteur (100), comprenant
- la fourniture d'un corps semi-conducteur (10) avec un côté de dessus (11) et un côté de dessous (19),
- la formation d'au moins deux tranchées, à savoir une tranchée de premier type (51) et une tranchée de deuxième type (52), s'étendant chacune depuis le côté de dessus (11) jusque dans le corps semi-conducteur (10),
- la formation d'une première électrode principale (2) sur le côté de dessus (11) et d'une deuxième électrode principale (3) sur le côté de dessous (19),
- la formation d'une électrode grille (4) de telle sorte que l'électrode grille (4) s'étende jusque dans la tranchée de premier type (51) où elle est séparée du corps semi-conducteur (10) par une couche d'isolation de grille (40), dans lequel
- la tranchée de deuxième type (52) est gardée exempte de l'électrode grille (4),
- le dispositif semi-conducteur (100) est formé de telle sorte que le corps semi-conducteur (10) comprenne
- une région de dérive (14) d'un premier type de conductivité verticalement entre le côté de dessus (11) et le côté de dessous (19),
- au moins deux régions de base, à savoir une première (13a) et une deuxième (13b) région de base, chacune d'un deuxième type de conductivité et chacune agencée verticalement entre la région de dérive (14) et le côté de dessus (11),
- une région d'injection (12) du premier type de conductivité, espacée verticalement de la région de dérive (14) par la première région de base (13a) et attenante à la première région de base (13a),
- la première région de base (13a), la tranchée de premier type (51), la deuxième région de base (13b) et la tranchée de deuxième type (52) sont agencées dans cet ordre l'une après l'autre dans une première direction latérale,
- la première électrode principale (2) est en contact électrique avec la zone d'injection (12),
- la deuxième région de base (13b) comprend une pluralité de zones de contact (6b) espacées latéralement, la deuxième région de base (13b) étant en contact électrique avec la première électrode principale (2) dans chacune de ces zones de contact (6b),
- les zones de contact (6b) dans la deuxième région de base (13b) sont espacées l'une de l'autre dans une deuxième direction latérale qui est perpendiculaire à la première direction latérale,
**caractérisé en ce que**
- la distance entre la tranchée de premier type (51) et la tranchée de deuxième type (52) mesurée dans la première direction latérale varie lors d'un déplacement le long de la deuxième direction latérale,
- la distance entre la tranchée de premier type (51) et la tranchée de deuxième type est plus grande là où une zone de contact (6b) est agencée entre elles et plus petite là où aucune zone de contact n'est agencée entre elles, et
en outre **caractérisé en ce que**
- les tranchées (51, 52) sont formées de telle sorte que la tranchée de deuxième type (52) s'étende plus profondément dans le corps semi-conducteur (10) que la tranchée de premier type (51).

12. Procédé selon la revendication 11, dans lequel
- les tranchées (51, 52) sont formées à une étape de gravure commune à l'aide d'un masque commun (200),
- le masque (200) comprend des trous dans les régions où les tranchées (51, 52) doivent être formées,
- le trou pour la tranchée de deuxième type (52) a une plus grande largeur que le trou pour la tranchée de premier type (51).
